# EUROPEAN PATENT APPLICATION

(11) **EP 0 849 789 A2**
(43) Date of publication of application: **24.06.1998**
(21) Application number: 97310469.8
(22) Date of filing: 22.12.1997
(51) Int. Cl.: H01L 21/768, H01L 21/3105

(54) **Method of etching a multilayer IC dielectric structure**

(30) Priority: 20.12.1996 US 33727 P
(71) Applicant: TEXAS INSTRUMENTS INCORPORATED, Dallas Texas 75265 (US)
(72) Inventor: Aldrich, David B., Plano, Texas 75023 (US); McAnally, Peter S.,, McKinney, Texas 75070 (US)
(74) Representative: Darby, David Thomas

(57) **Abstract**

A method of etching an integrated circuit structure in which the gas flows into the etch plasma are changed to compensate for the change in the etch chemistry which occurs when deep features (high aspect ratio) or multilayer structures are etched. This innovative process divides the etch into multiple steps and changes the etch parameters during each stage of the etch in response to the materials being etched during that stage of the etch.

## Description

### FIELD OF THE INVENTION

The present invention generally relates to a method of fabricating integrated circuits and more particularly to etching a multilayer interlevel dielectric in an integrated circuit.

### BACKGROUND OF THE INVENTION

In modern integrated circuit fabrication, it is increasingly necessary to etch deep holes which have a high "aspect ratio" (i.e. a ratio of height to width which is 2:1 or more, and may be 10:1 or more in future products). During such deep etching, the etch chemistry in the deep features is different than that at the surface. This change in chemistry alters the behavior of the etch and can lead to undesirable results.

One particular problem with multilevel dielectrics is where the composition is not uniform. In particular, planarizing layers are necessarily of nonuniform thickness, and hence the duration of their etching is unpredictable.

This is most especially a problem when a low-oxygen spin-on glass (SOG) (such as Hydrogen Silsesquioxane, or "HSQ") is used as a planarizing layer. In this case the present inventors have discovered that excess polymer formation can occur when a normal chemistry for etching SiO2 hits this layer (which has a silicon:oxygen composition ratio close to 1:1.5).

Currently, it is common practice to maintain the same plasma/etch parameters throughout the entire etch. However, the reactions which occur during the initial point of the etch are different than the rest of the etch. (In reality, the chemistry of the etch probably changes continuously during the entire etch). It is generally believed that during the initial part of the etch, all exposed materials are etched until the etch "builds up selectivity" (possibly by the formation of protective polymers/residues, such as teflon). As the etch progresses, the chemistry of the gas/solid interface will change (especially in the case of etching high-aspect-ratio holes where the transport of material in and out of the hole is inhibited by the small dimensions).

Anisotropic plasma etch processes commonly form some deposit on the sidewalls of the etched hole. This deposit is normally prevented from building up on the bottom of the hole by ion bombardment. This deposit helps to provide the high ratio of vertical etching to horizontal etching which is necessary to achieve a highly anisotropic plasma etch. However, the chemistry which causes the formation of such deposits needs to be carefully controlled. In particular, in the case of fluorine-based etch chemistries which are normally used to etch oxides, these same chemistries may form deposits of fluorocarbon polymers which are quite tenacious. If these polymers begin to accumulate on the bottom of the etch hole, the etch will be greatly slowed or stopped. The present application describes a new approach to control such polymer accumulations.

### SUMMARY OF THE INVENTION

The present application discloses an innovative method in which the gas flows into the etch plasma are modified to compensate for the change in the etch chemistry which occurs when deep features (high aspect ratio) or multilayer structures are etched. Specifically, a multilayer dielectric structure can include an upper portion which contains a higher net excess of polymer-etchant atoms (such as oxygen) over polymer-precursor atoms (such as carbon) than a lower portion does; and in this case the etchant source gas is changed to include a higher fraction of the polymer-etchant atoms and/or a lower fraction of the polymer-precursor atoms for etching the lower layer.

Advantages of the disclosed methods and structures include:
greater process margin when deep etching in single layers or etching multiple layer structures by adjusting the etch parameters;
optimizes the etching of each layer and of the entire etch; and
more choices in selecting a planarizing layer.

### BRIEF DESCRIPTION OF THE DRAWINGS

The disclosed inventions will be described with reference to the accompanying drawings, which show important sample embodiments of the invention and which are incorporated in the specification hereof by reference, wherein:
Figure 1 shows a process flow for deep etching an integrated circuit structure; and
Figures 2A and 2B show a sample structure to which the disclosed etching process can advantageously be applied.

### DETAILED DESCRIPTION OF THE EMBODIMENTS

The numerous innovative teachings of the present application will be described with particular reference to the presently preferred embodiment. However, it should be understood that this class of embodiments provides only a few examples of the many advantageous uses of the innovative teachings herein. In general, statements made in the specification of the present application do not necessarily delimit any of the various claimed inventions. Moreover, some statements may apply to some inventive features but not to others.

In normal Freon chemistry (e.g. C2F6), the fluorine removes the silicon as SiF4, and the introduced carbon is removed by the oxygen, which is a polymer etchant, in the dielectric layer (e.g. SiO2) being etched. However, once the etched surface is covered with a polymer, there is no longer a source of oxygen to remove the remaining carbon. This creates an avalanche effect in which the formation of polymers enables more polymers to be formed. Thus, an oxygen-deficient layer (e.g. an HSQ-derived glass layer) during an oxide etch poses a significant etch stop problem.

In order to overcome this problem, in accordance with a preferred embodiment of the invention, an oxygen-enriched source is used when etching an oxygen-deficient layer to punch through the polymer buildup. However, oxygen degrades the photoresist profile and lowers the selectivity to underlying layers, and therefore, this oxygen-enriched source is preferably not used throughout the entire etch, but only when etching the oxygen-deficient layer.

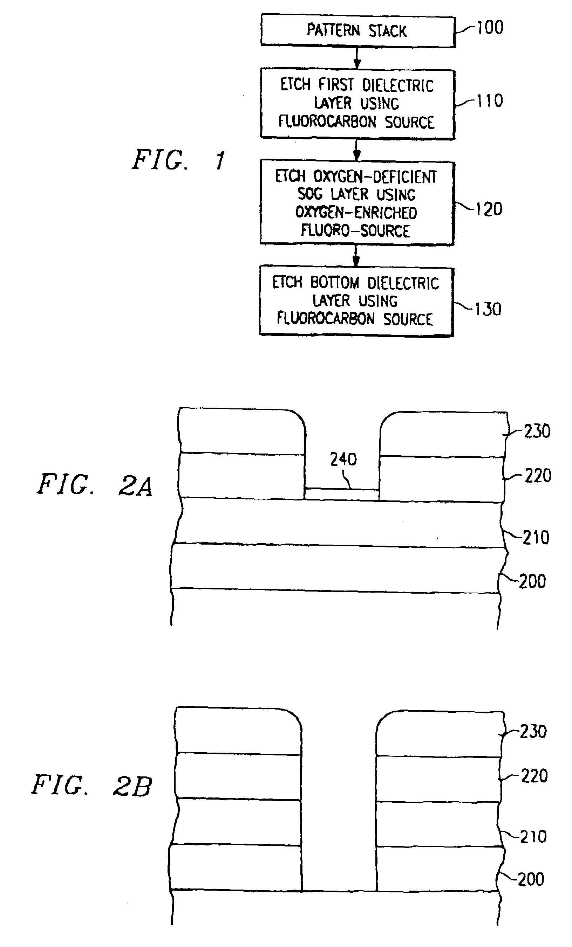

Figure 1 shows a process flow for deep etching an integrated circuit structure and Figures 2A and 2B show a sample structure that contains a layer of oxygen-deficient spin-on glass (SOG) 210 in between a top TEOS layer 220 and a bottom TEOS layer 200, to which the disclosed etching process can advantageously be applied, in accordance with the preferred embodiment of the present invention. The stack is first patterned (step 100) using a photoresist 230 to indicate locations where contacts are to be formed. A first etching chemistry, typically comprising C2F6, is used to etch through the top layer of TEOS 220 (step 110). Once the oxygen-deficient SOG layer 210 is reached, polymers 240 begin to form, reducing the etch efficiency, as shown in Figure 2A. Therefore, the etch chemistry is modified to include an oxygen-enriched source, such as C2F6 and oxygen, to break down the build-up of polymers and effectively etch the SOG layer 210 (step 120), as can be seen in Figure 2B. The etch chemistry can then optionally be changed again when etching the bottom layer of TEOS 200 by eliminating the oxygen-enriched source (step 130).

The following data illustrates results obtained from actual test runs using sample embodiments of the present invention. The multistage etch of the preferred embodiment was used as a contact etch on a TEOS/SOG/TEOS stack having a total thickness of around 1.2 microns. This test run was performed on a six inch wafer at a constant temperature. The spun thickness of the oxygen-deficient SOG layer is approximately 350 nm, and the bottom TEOS layer preferably has a thickness of around 100 nm.

| ETCH THROUGH TOP TEOS LAYER | |
|---|---|
| C2F6 Flow | 15 sccm |
| Power | 2300 W |
| Bottom (bias) Power | 800 W |
| Pressure | 5 mTorr |
| Time | 120 sec |

| ETCH OXYGEN-DEFICIENT SOG LAYER | |
|---|---|
| C2F6 Flow | 15 sccm |
| Oxygen Flow | 5 sccm |
| Power | 2300 W |
| Bottom (bias) Power | 800 W |
| Pressure | 5 mTorr |
| Time | 5 sec |

| ETCH BOTTOM TEOS LAYER | |
|---|---|
| C2F6 Flow | 15 sccm |
| Power | 2300 W |
| Bottom (bias) Power | 800 W |
| Pressure | 5 mTorr |
| Time | 60 sec |

Another oxygen source which can be used to prevent the build-up of polymers when etching oxygen-deficient layers is H20.

Alternatively, N2O can be used to prevent the build-up of polymers when etching oxygen-deficient layers.

Alternatively, during the entire etching of silicon and oxygen containing materials, the use of an oxygen-enriched source can be alternated with the normal fluorocarbon source at regular intervals to prevent the formation of polymers, especially when etching oxygen-deficient materials.

In an alternative embodiment, the flow rate of carbon can be decreased during fluorine based etches of silicon oxide materials. By varying to a carbon-depleted chemistry instead of, or in addition to, a more oxygen-enriched chemistry, the build-up of carbon-based polymers during the etching of an oxygen-deficient layer can be reduced.

Alternatively, a boron and fluorine-based chemistry (e.g. BF3) can be used to etch the stack. Boron-based chemistries do not precipitate the formation of polymers that can build-up on oxygen-deficient layers as much as carbon and fluorine-based chemistries. Therefore, an additional oxygen source is usually not needed to etch oxygen-deficient layers. However, to prevent any build-up of polymers, an oxygen-enriched source can be used during the etching of the oxygen-deficient layer or can be alternated with the boron and fluorine-based chemistry throughout the entire stack etch.

Furthermore, nitrogen and fluorine-based chemistries, such as NF3, also produce decreased amounts of polymers during oxide etches.

Alternatively, the hydrogen content of the plasma can be increased during the etch to compensate for the reduction or loss of photoresist. Increased levels of hydrogen in oxide etches can increase the rate and degree of polymer formation, and this increased polymer formation can protect the sidewalls of the material being etched as the resist is consumed. For example, HF or H2 can be added to the plasma source.

The addition of CHF3 during the etching of silicon oxygen containing materials enhances the formation of polymers on the surface of the material being etched.

The use of C3F8 during oxide etches also increases the polymer formation on the layer being etched.

Alternatively, CF4 can be used to etch the overlying layers of dielectric material before reaching the oxygen-deficient layer, or can be alternated with an oxygen-enriched source throughout the entire etch of the silicon oxide stack. However, CF4 provides less selectivity than C2F6, which is used in the preferred embodiment.

In an alternative embodiment, C4F8 can be substituted for C2F6 during the oxide etch to increase the carbon:fluorine ratio. Presently, C4F8 is becoming commonly used in the etching of dielectric layers.

The teachings of the above embodiments can also be adapted for use with organic polymers (such as parylene, polyimide, or Teflon), to avoid the excess build-up of carbon-based polymers when an oxide etch encounters a layer of these carbon-rich materials. Thus the etchant source gas will be made more oxygen-rich or carbon-poor when these layers must be etched.

The build-up of polymers that occurs when etching oxygen-deficient (e.g. HSQ SOG) layers can advantageously be used to create an etch stop on this layer. By increasing the flow of carbon or decreasing the flow of oxygen during the etch of an oxide stack containing an oxygen-deficient layer, the etch will stop on the SOG layer. This etch stop capability is advantageous because variations in the characteristics of overlying layers, such as the thickness or density, do not have to be accounted for. The oxygen-deficient SOG layer can then easily be etched using the innovative process of the present invention described herein.

According to a disclosed class of innovative embodiments, there is provided: a method of etching a multilayer integrated circuit dielectric structure which includes, in at least some locations, an upper portion overlying a lower portion, and wherein said upper portion contains a higher net excess of polymer-etchant atoms over polymer-precursor atoms than does said lower portion, comprising the steps of: a) etching said upper portion using plasma-excitation of a first fluorine-containing chemistry; and b) etching said lower portion using plasma-excitation of a second fluorine-containing chemistry which contains a larger net excess of polymer etchant atoms over polymer-precursor atoms than said first chemistry; whereby the formation of polymers on said lower portion is prevented.

According to a disclosed class of innovative embodiments, there is provided: a method of etching a multilayer integrated circuit dielectric structure which includes, in at least some locations, an upper oxide portion overlying a lower portion, both said portions comprising silicon and oxygen, said lower portion containing a smaller atomic fraction of oxygen than said upper portion, comprising the steps of: a) etching said upper portion using plasma-excitation of a first fluorine-containing chemistry; and b) etching said lower portion using plasma-excitation of a second fluorine-containing chemistry which contains a higher fraction of oxygen than said first chemistry; whereby the formation of polymers on said lower portion is prevented.

According to a disclosed class of innovative embodiments, there is provided: a method of etching a multilayer integrated circuit dielectric structure which includes an upper portion overlying a lower portion, and wherein said upper portion contains a higher net excess of polymer-etchant atoms over polymer-precursor atoms than does said lower portion, comprising the steps of: a) etching through said upper portion using plasma-excitation of a first fluorine-containing chemistry which does not form polymers on horizontal portions of said upper layer, but forms polymers on horizontal portions of said lower layer and substantially stops etching; and b) etching through said lower portion using plasma-excitation of a second fluorine-containing chemistry which contains a higher net excess of polymer etchant atoms over polymer-precursor atoms than does said first chemistry; whereby said lower portion provides an etch stop for said etching step a).

As will be recognized by those skilled in the art, the innovative concepts described in the present application can be modified and varied over a tremendous range of applications, and accordingly the scope of patented subject matter is not limited by any of the specific exemplary teachings given.

Of course, the specific etch chemistries, layer compositions, and layer thicknesses given are merely illustrative, and do not by any means delimit the scope of the claimed inventions.

The invention can also be adapted to other combinations of dielectric materials in the interlevel dielectric. For example, phosphosilicates, germanosilicate, arsenosilicates or combinations thereof can be used.

Other chemistries which can be used to vary the amount of polymer formation during oxide etches include CO, CO2, and C2F4O.

## Claims

1. A method of etching a multilayer integrated circuit dielectric structure which includes, in at least some locations, an upper portion overlying a lower portion, and wherein said upper portion contains a higher net excess of polymer-etchant atoms over polymer-precursor atoms than does said lower portion, comprising the steps of:
etching said upper portion using plasma-excitation of a first fluorine-containing chemistry; and
etching said lower portion using plasma-excitation of a second fluorine-containing chemistry which contains a larger net excess of polymer etchant atoms over polymer-precursor atoms than said first chemistry;
whereby the formation of polymers on said lower portion is prevented.

2. The method of Claim 1, wherein said second chemistry predominantly comprises C2F6 and oxygen.

3. The method of Claim 1 or Claim 2, wherein said first chemistry predominantly comprises C2F6.

4. The method of any of Claims 1 to 3, wherein said first chemistry and said second chemistry are alternated more than once.

5. The method of any of Claims 1 to 4, wherein said lower portion substantially comprises SiOx with x less than 1.9.

6. The method of any of Claims 1 to 5, wherein said second chemistry contains a higher fraction of oxygen than said first chemistry.

7. The method of any of Claims 1 to 6, wherein said second chemistry contains a lower fraction of carbon than said first chemistry.

8. The method of any of Claims 1 to 7, further comprising the subsequent step of:
further etching using plasma-excitation of said first fluorine-containing chemistry.

9. The method of any of Claims 1 to 8, wherein said lower portion comprises at least ten percent atomic of carbon.

10. The method of any of any of Claims 1 to 9, wherein said lower portion is an organic polymer.

11. The method of Claims 1 to 10, wherein said upper portion predominantly comprises SiO2.

12. A method of etching a multilayer integrated circuit dielectric structure which includes, in at least some locations, an upper oxide portion overlying a lower portion, both said portions comprising silicon and oxygen, said lower portion containing a smaller atomic fraction of oxygen than said upper portion, comprising the steps of:
etching said upper portion using plasma-excitation of a first fluorine-containing chemistry; and
etching said lower portion using plasma-excitation of a second fluorine-containing chemistry which contains a higher fraction of oxygen than said first chemistry;
whereby the formation of polymers on said lower portion is prevented.

13. The method of Claim 12, wherein said second chemistry predominantly comprises C2F6 and oxygen.

14. The method of Claim 12 or Claim 13, wherein said first chemistry predominantly comprises C2F6.

15. The method of any of Claims 12 to 14, wherein said first chemistry and said second chemistry are alternated more than once.

16. A method of etching a multilayer integrated circuit dielectric structure which includes an upper portion overlying a lower portion and wherein said upper portion contains a higher net excess of polymer-etchant atoms over polymer-precursor atoms than does said lower portion, comprising the steps of:
first etching through said upper portion using plasma-excitation of a first fluorine-containing chemistry which does not form polymers on horizontal portions of said upper layer, but forms polymers on horizontal portions of said lower layer and substantially stops etching; and
second etching through said lower portion using plasma-excitation of a second fluorine-containing chemistry which contains a higher net excess of polymer etchant atoms over polymer-precursor atoms than does said first chemistry;
whereby said lower portion provides an etch stop for said first etching step.

17. The method of Claim 16, wherein said first chemistry predominantly comprises C2F6.

18. The method of Claim 16 or Claim 17, wherein said lower portion substantially comprises SiOx with x less than 1.9.

19. The method of any of Claims 16 to 18, wherein said lower portion substantially comprises a high-organic-contact Siox with x less than 1.9.
